**Europäisches Patentamt**

**European Patent Office**

**Office européen des brevets**

(19)

(11) Publication number: **0 069 649**
**B1**

(12) **EUROPEAN PATENT SPECIFICATION**

(45) Date of publication of patent specification: **19.04.89**

(51) Int. Cl.⁴: **H 01 L 27/14, H 04 N 3/15**

(21) Application number: **82401195.1**

(22) Date of filing: **28.06.82**

(54) **Self-aligned antiblooming structure for charge-coupled devices and method of fabrication thereof.**

(30) Priority: **10.07.81 US 282198**

(43) Date of publication of application:
**12.01.83 Bulletin 83/02**

(45) Publication of the grant of the patent:
**19.04.89 Bulletin 89/16**

(84) Designated Contracting States:
**DE FR GB IT NL**

(56) References cited:
**FR-A-2 337 428**
**US-A-3 845 295**
**US-A-4 125 933**
**US-A-4 173 064**
**PATENTS ABSTRACTS OF JAPAN, vol. 5, no.**
**121(E-68)(793), 5th August 1981; & JP - A - 56**
**58282 (TOKYO SHIBAURA DENKI K.K.) 21-05-**
**1981 (Cat. Y)**
**Idem**

**The file contains technical information
submitted after the application was filed and
not included in this specification**

(73) Proprietor: **FAIRCHILD CAMERA &**
**INSTRUMENT CORPORATION**
**464 Ellis Street**
**Mountain View California 94042 (US)**

(72) Inventor: **Dyck, Rudolph H.**
**160 Ely Place**
**Palo Alto California 94306 (US)**
Inventor: **Early, James M.**
**740 Center Drive**
**Palo Alto California 94301 (US)**

(74) Representative: **Chareyron, Lucien et al**
**Schlumberger Limited Service Brevets c/o Giers**
**12, place des Etats Unis B.P. 121**
**F-92124 Montrouge Cédex (FR)**

(56) References cited:
**PATENTS ABSTRACTS OF JAPAN, vol. 5, no.**
**117(E-67)(789), 28th July 1981; & JP - A - 56**
**56682 (TOKYO SHIBAURA DENKI K.K.) 18-05-**
**1981 (Cat. Y)**
**Idem**

Courier Press, Leamington Spa, England.

## Description

This invention relates to integrated circuit structures and in particular to a self-aligned antiblooming structure for individual elements of a charge-coupled device image sensor.

Description of the prior art

The phenomenon in charge-coupled device (CCD) image sensors in which excess signal charge from saturated sensor elements spills into adjacent sensor elements or shift registers is known as blooming. When this excess charge spills into an adjacent shift register, it generally mixes with the signal charge from a large number of pixels, thereby causing a particularly objectionable type of blooming. This type of blooming produces a vertical streak in the image wherever a saturated pixel occurs.

Strucutres in image sensors which prevent or limit blooming are known as antiblooming structures. The most complete blooming prevention requires an antiblooming structure at each sensor element so that the individual elements cannot bloom. This function has been referred to as element antiblooming to distinguish it from the much less effective prior art column antiblooming function which limits blooming to the vertical column in which the saturated element occurs. JP—A—56 58282 discloses a method for manufacturing semiconductor devices wherein self-alignment of implanted barrier and charge sink regions of an antiblooming structure is performed by employing an additional mask underetching step between the sink and barrier implantations. Charge sink regions are surrounded by but not disposed wholly within the barrier regions.

Summary of the invention

It is a general object of this invention to provide an improved antiblooming structure for an integrated circuit and a method for producing this structure.

This and other objects are attained, in accordance with one aspect of the invention, by a method of fabricating an antiblooming barrier for a charge coupled device having photosensors formed in a substrate comprising the steps of:

forming an opening in a masking layer disposed on a substrate of a first conductivity type;

introducing impurities of both a first and an opposite conductivity type into said substrate through the opening where the impurity of the first type has a higher diffusion coefficient than the impurity of the opposite type; and

driving the first and opposite conductivity type impurities into the substrate by heating until the impurity of the first conductivity type diffuses far enough past the impurity of the opposite conductivity type so as to surround the region in the substrate having a higher concentration of opposite conductivity type impurity to form thereby a barrier potential in the substrate of a predetermined value related to the desired maximum saturation level of charge for the photosensors.

Another aspect of the invention includes an integrated circuit structure comprising:

a semiconductor substrate of first conductivity type, the substrate including a region of opposite conductivity type for containing charge and from which charge in excess of a selected amount is to be removed; a barrier region of first conductivity type more strongly doped than the substrate, the barrier region disposed in the substrate adjacent the charge-containing region and extending into the substrate to a first depth for allowing charge in excess of a selected amount to pass through the barrier region; and a charge sink region of opposite conductivity type disposed wholly within the barrier region for draining charge passing through that portion of the barrier region between the charge sink region and the charge-containing region, the charge sink region extending into the substrate a second depth less than the first depth and being separated from both the charge-containing region and the substrate by the barrier region. Particular embodiments of the invention are set out in the dependent claims.

Brief description of the drawings

Fig. 1a is a schematic drawing of an interline transfer CCD.

Fig. 1b is a top view of a portion of an interline transfer charge-coupled imaging device fabricated with the self-aligned element antiblooming structure.

Fig. 1c is a schematic representation of the potential wells created by the structure of Fig. 1b.

Fig. 2 is an enlarged cross-sectional view of a portion of the structure shown in Fig. 1b.

Fig. 3a is a schematic drawing of a frame transfer charge-coupled device.

Fig. 3b is a perspective view of a frame transfer charge-coupled area imaging device utilizing the element antiblooming structure.

Fig. 3c is a diagram showing the potential wells created by the structure shown in Fig. 3b.

Fig. 4 is a graph showing typical N and P type impurity concentrations as a function of depth in the silicon substrate for the structure shown in Fig. 2.

Fig. 5 is a graph showing the relationship between the concentration of the P and N type impurities as related to the lateral distance from the edge of the implant mask.

Fig. 6a is a top view of a portion of a four phase charge coupled area imaging device.

Fig. 6b is a schematic showing the potential well created in a cross-section of Fig. 6a.

Fig. 6c is a schematic showing a potential well created by the structure 6a in another cross-section.

Fig. 7a is a top view of a portion of a two-phase charge coupled device.

Fig. 7b is a schematic diagram showing the potential wells created in a first cross-section of the structure in Fig. 7a.

Fig. 7c is a schematic diagram of the potential wells created in a second cross-section of the structure shown in Fig. 7a.

Fig. 8a is a top view of a portion of an interline transfer charge-coupled device.

Fig. 8b is a schematic diagram of the potential wells created by the structure of Fig. 8a.

Fig. 9a is a top view of a portion of a 1—1/2 phase charge-coupled device.

Fig. 9b is a schematic diagram of the potential wells created by the structure shown in Fig. 9a.

Description of the preferred embodiments

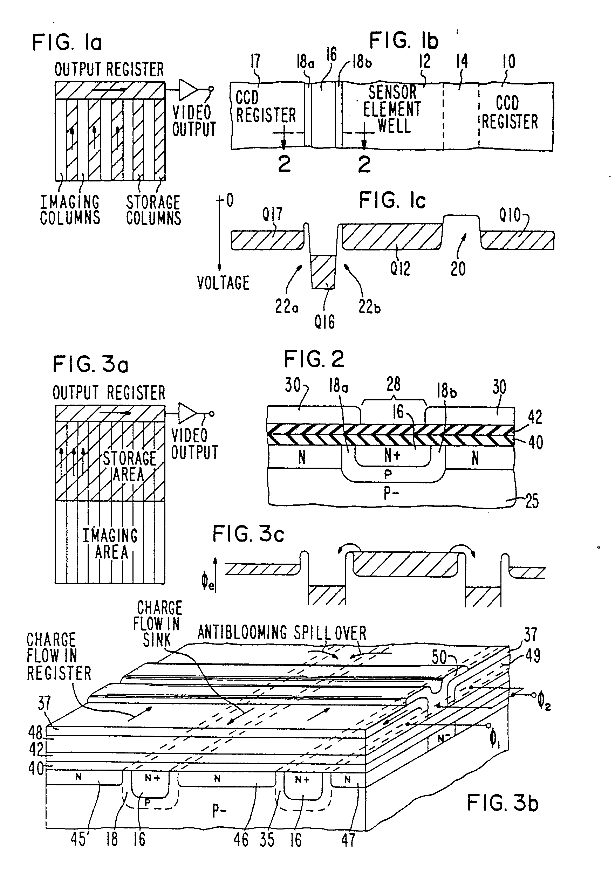

Fig. 1a is a schematic view of an interline transfer charge coupled device. In a known manner charge is accumulated in the imaging columns, transferred to the storage columns and then supplied to the video output by the output register. Fig. 1b is an enlarged top view of a portion of Fig. 1a illustrating a buried channel interline transfer charge-coupled device employing the element antiblooming structure of this invention. The structure depicted includes a charge-coupled device shift register or storage column 10 and a sensor element well 12 separated by a transfer gate 14. In operation ambient light striking the surface of sensor element well 12 causes the accumulation of electrons in the underlying substrate. After a desired interval, the potential of transfer gate 14 is changed to permit the accumulated charge from well 12 to flow into register 10. Register 10 then transfers the accumulated charge to a charge detector or to another shift register. The self-aligned element antiblooming structure of this invention is formed adjacent the other side of sensor element well 12 from register 10. As shown in Fig. 1b a charge sink 16 has antiblooming barriers 18a and 18b disposed on each side. As will be explained, the antiblooming barriers 18a and 18b provide a slightly lower barrier height than does the transfer gate 14.

Fig. 1c is a schematic diagram of the potential barriers and accumulated charge created by the structure shown in Fig. 1b. As shown in Fig. 1c transfer gate 14 creates a potential barrier 20 while antiblooming barriers 18a and 18b create potential barriers 22a and 22b, respectively. The charge accumulating in sensor element well 12 is designated Q12, while the charge collected in register 10 and in register 17 is designated Q10 and Q17, respectively. Charge in sink 16 is shown as Q16. As shown in Fig. 1c, the antiblooming barriers 18a and 18b are fabricated to create barriers 22a and 22b having potential heights which are slightly lower than the potential height of transfer gate 14 separating well 12 from register 10. In this manner any charge in excess of the amount Q12 permitted by barrier 18b will drain into sink 16 where it may be harmlessly conducted away. The charge level in the individual elements of registers 10 and 17 depicted in Fig. 1b may be maintained at a lower level than the potential height of the antiblooming barriers 18a and 18b by fabricating the elements of the CCD register 10 or 17 to be larger than the maximum amount of charge, for example Q12, which may accumulate in any individual photoelement well.

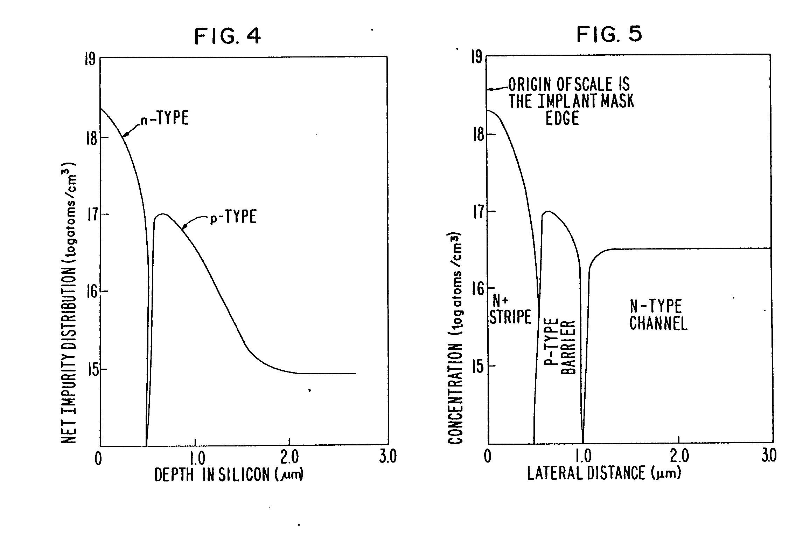

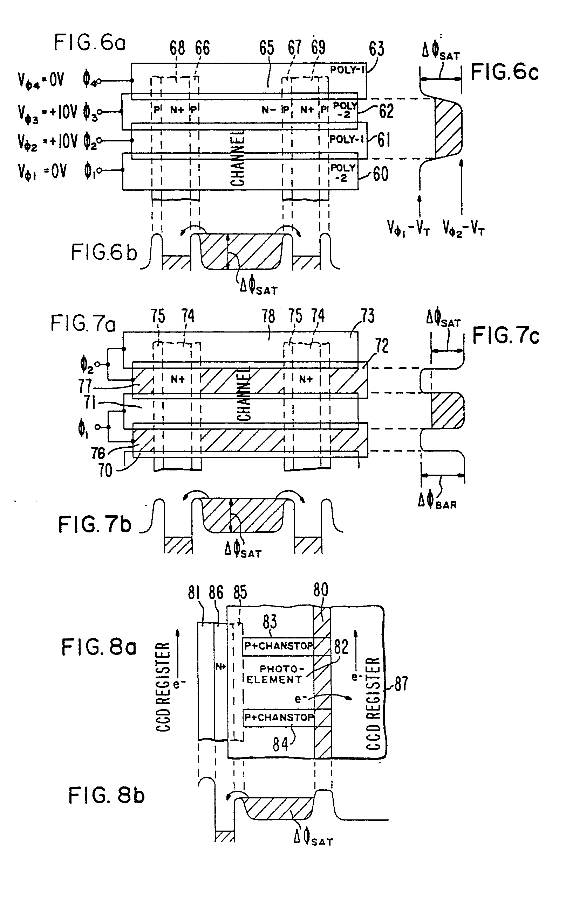

Fig. 2 is an enlarged cross-sectional view taken through the structure of Fig. 1b. As shown in Fig. 2 the sink 16 and the antiblooming barriers 18a and 18b are created by regions of impurity introduced into substrate 25. Sink 16 comprises a strongly doped N conductivity type region, which in the preferred embodiment is created by implanting arsenic ions into the silicon substrate 25. Antiblooming barriers 18a and 18b, which are each portions of a single P conductivity type region 18, are created by implanting boron ions into substrate 25. Both the boron and the arsenic ions are introduced through an opening 28 in a layer of photoresist 30. The doses of impurity dopants and resulting concentration profiles are discussed in conjunction with Figs. 4 and 5 below. The volume of the silicon substrate 25 that is lost with respect to useful photoresponse as a result of fabricating the sink 16 and antiblooming barriers 18 is less than that of the doped regions 16 and 18 themselves. As known in charge-coupled device fabrication technology, a layer of silicon dioxide 40 and an overlying layer of silicon nitride 42 may be formed on the surface of silicon 25 before photoresist layer 30 is formed.

Fig. 3a is a schematic diagram of a known frame transfer charge coupled device. As illustrated charge is accumulated in an imaging area, then transferred sequentially to a storage area and to a video output terminal via an output register. A perspective view of the self-aligned element antiblooming structure of this invention as applied to the photosensitive imaging area of a frame transfer device is shown in Fig. 3b, with gate electrodes 48, 49 and 50 in place. The self-aligned element antiblooming portion of the structure shown in Fig. 3b is fabricated in the same manner as discussed in conjunction with Fig. 2. The remainder of the structure is fabricated using known CCD fabrication technology. These processes are briefly discussed below.

The structure shown in Fig. 3b generates a potential configuration which is shown in Fig. 3c. By contacting the N conductivity type stripe 16 externally, the barrier height in the adjoining P type region 18 may be adjusted to be lower than that of the adjacent clocked barrier. As discussed in conjunction with Fig. 2 this will cause signal charge in excess of the register saturation level to spill into the N type stripe. The minimum width necessary to obtain the desired antiblooming barrier potential is determined by the breakdown voltage of the junction between the N type stripe 16 and the P type barrier 18. A dose of arsenic ions on the order of $3\times10^{13}$ ions per cm$^2$ is first implanted into the substrate through implant windows in the overlying photoresist at desired locations. The arsenic dopant creates a series of sink regions 16 as shown in Fig. 3b. Next a dose of boron ions on the order or $2\times10^{13}$ ions per cm$^2$ are implanted into the now arsenic doped region using the same implant windows in the photoresist mask. The photoresist is removed and the implants are diffused into the substrate at a high temperature. A suitable procedure is to hold a temperature on the order of 1100°C for 60 to 240 minutes. Because boron diffuses approximately 2.5 times faster in silicon than does arsenic at 1100°C, the distribution of arsenic 16 will remain relatively confined while the boron will diffuse outward approximately 1 micrometer to form antiblooming barriers 18 and 35 as shown in Figs. 2 and 3b. In the embodiment depicted in Fig. 3b, substrate 25 will also include a series of registers 45, 46 and 47 in which the silicon substrate had been doped with N type impurity to a concentration of $10^{16}$ atoms per cubic centimeter. The width of the P type barrier region 18 may be adjusted by altering the length of the diffusion time after implanting both the arsenic and boron ions. The P barrier will be approximately one micrometer wide for a diffusion lasting 200 minutes. Of course, the boron implant energy may be increased to cause lateral scattering of the boron ions and thereby reduce the duration of the diffusion.

The structure of Fig. 3b may be completed using conventional charge-coupled device fabrication techniques. After the antiblooming barrier and sink are diffused, buried channel implants 45 and 46 are performed. Then a sequence of polycrystalline electrodes 48, 49, 50 etc. may be formed across the surface of silicon nitride 42 separated by silicon dioxide 37. For a two-phase charge-coupled device, alternate pairs of electrodes will be connected to a first phase clock signal while the remaining electrodes 49 and 50 will be connected to an opposite clock signal. The resulting structure includes a heavily doped N conductivity type register which is isolated from adjacent registers by a diffused pair of lateral P conductivity type barriers 18 and 35.

Fig. 4 shows the estimated impurity distribution of the element antiblooming barriers shown in Figs. 2 and 3b as a function of depth in substrate 25. The distribution depicted is for an arsenic implant of $6 \times 10^{13}$ ions per square centimeter, a boron implant of $2 \times 10^{13}$ ions per square centimeter and for 45 minutes diffusion at 1100°C.

Fig. 5 shows the impurity concentrations of the element antiblooming barrier as a function of the lateral distance from the edge of the implant window in the photoresist mask. This is the edge, for example, of photoresist 30 in Fig. 2. Fig. 5 assumes an arsenic implant of $3 \times 10^{13}$ atoms per square centimeter and a boron implant of $1.5 \times 10^{13}$ atoms per square centimeter.

Figs. 6 through 9 illustrate other applications of the self-aligned element antiblooming barrier of this invention in addition to those discussed above. Fig. 6a shows application of the antiblooming barrier to a four-phase charge-coupled device. The application depicted is also appropriate for a three-phase charge-coupled device. As shown in Fig. 6a a four-phase charge-coupled device includes overlapping, but electrically separate, polycrystalline silicon electrodes 60, 61, 62 and 63. Each electrode is connected to one phase of a four phase clock signal. In a device such as the one depicted the packets of accumulated charge move forward along the channel 65 at essentially one potential determined by the high clock voltage. In the preferred mode of operation considered here, either two or three phases are high at any one time. Therefore, the antiblooming barrier may be fixed at one potential at all points along the channel during the portion of each clock cycle that is active. As shown in Figs. 6b and 6c, excess charge from the channel will overflow barriers 66 and 67 into the sinks 68 and 69 when two adjoining electrodes are clocked high. The process determines the saturation charge of the structure.

Figs. 7a, 7b, and 7c illustrate the application of the element antiblooming structure of this invention to a two-phase charge-coupled device. In Fig. 7a electrodes 70 and 71 are connected to the $\emptyset_1$ clock signal and electrodes 72 and 73 connected to the $\emptyset_2$ clock signal. The arsenic and boron implants comprising the sink and antiblooming barriers are designated 74 and 75, respectively. The barriers across the channel are cross-hatched and designated 76 and 77, respectively. Because of built-in barriers in a two-phase charge-coupled device, the bottom of each potential well must be raised over the periodic barriers to move the charge packets forward along the channel. Element antiblooming protection may best be achieved in a two-phase CCD if the clocks are operated in a non-overlapping mode in which both clock signals are simultaneously low for at least a very short time during each cycle. For this short time, on the order of tens of nanoseconds, Figs. 7b and 7c illustrate the operation of the antiblooming barriers.

As shown in Fig. 7b and 7c the antiblooming barriers 75 will drain away excess charge from the channel into the sink 74 when the charge packets are accumulated under a single electrode—electrode 71, shown in Fig. 7a. Because the potential height of barriers 76 and 77 is greater than that of the antiblooming barrier 75, the excess charge in channel 78 will overflow into sink 74 rather than over the leading barrier 77 or the trailing barrier 76.

Figs. 8a and 8b illustrate application of the element antiblooming barrier to an interline transfer television type of charge-coupled device array. In this application the antiblooming barriers are positioned only at the photoelement sites, and not at the CCD register. As shown in Fig. 8a a cell of an interline transfer device includes a photoelement barrier 80, a channel stop disposed along one side of the photoelement 82, together with channel stops 83 and 84 positioned perpendicular to the CCD register. The antiblooming barrier 85 and the N type sink 86 separate photoelement 82 from channel stop 81. In operation charge is accumulated in photoelement 82 and then transferred to CCD register 87 at desired intervals. As shown in Fig. 8b, the preferred mode of operation of the antiblooming barrier in an interline transfer device is with the photogate biased low most of the operating cycle. In this mode excess charge flows over barrier 85 into sink 86. The charge is precluded from flowing into CCD register 87 by photoelement barrier 80. This apparatus is similar in operation to the two-phase apparatus discussed in conjunction with Figs. 3a and 3b.

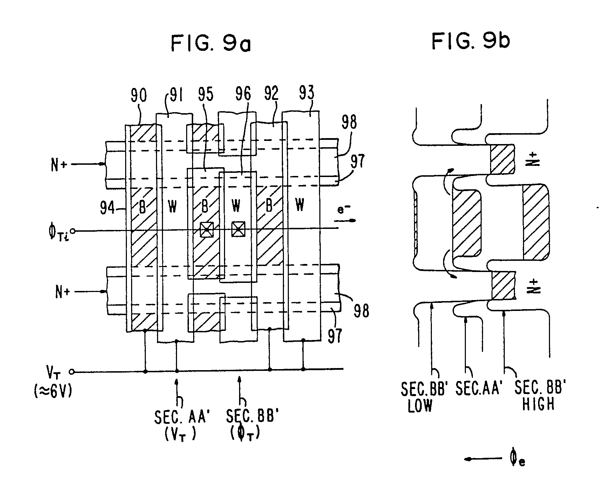

An application of the element antiblooming structure to a 1—1/2 phase charge-coupled device is shown in Figs. 9a and 9b as it might be used in an area imaging device of the line-by-line type. A 1-1/2 phase CCD register is identical to a two-phase register in design; however, the application of clock signals is different. In a 1-1/2 phase CCD register, a single clock of twice the amplitude is used. Because of the high amplitude, barrier modulation must be reduced to prevent charge from spilling back into the register from the adjoining sink. As shown in Fig. 9a, a series of electrodes 90, 91, 92 and 93 are disposed over a channel 94. These electrodes are connected to a desired potential, typically on the order of 6 volts. Electrodes 95 and 96 are disposed along the same channel and connected to a signal $\emptyset_T$ as shown. In the same manner as previously described, antiblooming barriers 97 and sinks 98 are disposed adjacent the length of channel 94.

Fig. 9b illustrates the operation of the antiblooming barriers as charge packets are transferred along channel 94. The antiblooming barrier is fabricated so as to be of the desired height in the dc phase $V_T$. Because of the inherent properties of such narrow channels, the barrier will be too high or too low in the clocked phase $\emptyset_T$, depending upon the bias state of that clock. As a result, the desired antiblooming barrier function is achieved whenever clock $\emptyset_T$ is low.

The antiblooming barrier of this invention may also be applied to other types of charge-coupled devices. For example, in types with photodiode sense elements a gate electrode to control the surface potential is impractical. The invention, however, permits such a narrow barrier, on the order of less than one micrometer, that the potential of the barrier region may be controlled simply by the potentials of adjacent regions, that is, the N type sink and the photodiode reset potential. The antiblooming barrier may also be applied to other signal processing devices.

It can be seen that the self-aligned element antiblooming structure of this invention provides several important advantages over prior art structures. There need not be any increase in the combined photoelement well/antiblooming structure size over charge-coupled devices not employing element antiblooming designs. In addition, the element antiblooming structure of this invention involves minimal processing complication in the manufacture of the charge-coupled device.

The foregoing explanation of the preferred embodiments of this invention is intended to be illustrative of the invention rather than as limiting it. The scope of the invention may be more readily ascertained with reference to the appended claims.

## Claims

1. A method of fabricating an antiblooming barrier (18) for a charge-coupled device having photosensors (12) formed in a substrate comprising the steps of:

forming an opening (28) in a masking layer (30) disposed on a substrate (25) of a first conductivity type;

introducing impurities of both a first and an opposite conductivity type into said substrate (25) through the opening (28) where the impurity of the first type has a higher diffusion coefficient than the impurity of the opposite type; and

driving the first and opposite conductivity type impurities into the substrate by heating until the impurity of the first conductivity type diffuses far enough past the impurity of the opposite conductivity type so as to surround the region (16) in the substrate having a higher concentration of opposite conductivity type impurity to form thereby a barrier potential (22a, 22b) in the substrate of a predetermined value related to the desired maximum saturation level of charge (Q12) for the photosensors (12).

2. A method as in claim 1 characterized in that diffusivity of the first conductivity type impurity is approximately 2.5 times the diffusivity of the opposite conductivity type impurity.

3. A method as in claim 2 characterized in that a higher concentration of the opposite conductivity type impurity is introduced than the concentration of the first conductivity type impurity.

4. A method as in claim 2 characterized in that the first conductivity type is P type and the opposite conductivity type is N.

5. A method as in claim 4 characterized in that the substrate (25) comprises silicon, the P type impurity comprises boron, and the N type impurity comprises arsenic.

6. A method as in claim 5 characterized in that the step of driving the two types of impurity is performed by heating the substrate (25) to at least 1000°C.

7. A method as in claim 6 characterized in that the substrate (25) is heated for at least 100 minutes.

8. A method as in claim 1 wherein the steps of introducing the first and the opposite conductivity type impurities comprise ion implanting the first and the opposite conductivity type impurities.

9. A method as in claim 1 wherein the steps of introducing the first and the opposite conductivity type impurities comprise doping the substrate (25) from a source.

10. A method as in claim 9 wherein the source comprises an overlying doped layer.

11. A method as in claim 9 wherein the source comprises a vapor.

12. An integrated circuit structure (Fig. 3b) comprising:

a semiconductor substrate of first conductivity type, the substrate including a region (46) of opposite conductivity type for containing charge and from which charge in excess of a selected amount is to be removed;

a barrier region (18) of first conductivity type more strongly doped than the substrate, the barrier region disposed in the substrate adjacent the charge-containing region and extending into the substrate to a first depth for allowing charge in excess of a selected amount to pass through the barrier region; and

a charge sink region (16) of opposite conductivity type disposed wholly within the barrier region (18) for draining charge passing through that portion of the barrier region between the charge sink region (16) and the charge-containing region (46), the charge sink region extending into the substrate a second depth less than the first depth and being separated from both the charge-containing region and the substrate by the barrier region.

13. A structure as in claim 12 characterized in that the substrate comprises silicon, the first conductivity type impurity comprises boron and the opposite conductivity type impurity comprises arsenic.

14. A structure as in claim 12 characterized in that charge-containing region (46) comprises a sensor element in a charge-coupled device.

15. A structure as in claim 14 characterized in that charge accumulates in the sensor element in response to incident light.

16. A structure as in claim 12 characterized in that charge-containing region comprises a shift register region beneath an electrode in a charge-coupled device.

17. A structure as in claim 16 characterized in that plurality of shift register regions are sequentially arranged.

18. A structure as in claim 17 characterized in that barrier region is disposed along an edge of the plurality of shift register regions.

19. A structure as in claim 12 comprising said barrier (18) and charge sink (16) regions and an antiblooming means for removing undesired charge from at least one of the photosensitive means and the transfer means of a charge-coupled device fabricated in said semiconductor substrate including photosensitive means for accumulating charge in response to ambient light and transfer means for transferring charge from the photosensitive means to another location in the substrate.

## Patentansprüche

1. Verfahren zum Herstellen einer Überlaufschutzsperre (18) für eine ladungsgekoppelte Vorrichtung mit in einem Substrat gebildeten Photosensoren (12), enthaltend die Schritte:

Erzeugen einer Öffnung (28) in einer Maskierungsschicht (30), die auf einem Substrat (25) eines ersten Leitungstyps angebracht ist;

Einbringen von Störstoffen sowohl eines ersten als auch eines entgegengesetzten Leitungstyps in das Substrat durch die Öffnung (28), wobei der Störstoff des ersten Typs einen größeren Diffusionskoeffizienten als der Störstoff des entgegengesetzten Typs hat; und

Eintreiben der Störstoffe des ersten und des entgegengesetzten Leitungstyps in das Substrat durch Erhitzen, bis der Störstoff des ersten Leitungstyps weit genug über den Störstoff des entgegengesetzten Leitungstyps hinaus diffundiert, so daß er den Bereich (16) in dem Substrat umgibt, der eine höhere Konzentration des Störstoffs des entgegengesetzten Leitungstyps hat, damit dadurch ein Sperrpotential (22a, 22b) in dem Substrat mit einem vorbestimmten Wert bezogen auf den gewünschten maximalen Ladungssättigungspegel (Q12) für den Photosensor (12) erzeugt wird.

2. Verfahren nach Anspruch 1, dadurch gekennzeichnet, daß das Diffusionsvermögen des Störstoffs des ersten Leitungstyps etwa 2,5 mal so groß wie das Diffusionsvermögen des Störstoffs des entgegengesetzten Leitungstyps ist.

3. Verfahren nach Anspruch 2, dadurch gekennzeichnet, daß der Störstoff des entgegengesetzten Leitungstyps mit höherer Konzentration als der Störstoff des ersten Leitungstyps eingebracht wird.

4. Verfahren nach Anspruch 2, dadurch gekennzeichnet, daß der erste Leitungstyp der P-Typ ist und der entgegengesetzte Leitungstyp der N-Typ ist.

5. Verfahren nach Anspruch 4, dadurch gekennzeichnet, daß das Substrat (25) auf Silicium besteht, daß der Störstoff des P-Typs Bor ist und daß der Störstoff des N-Typs Arsen ist.

6. Verfahren nach Anspruch 5, dadurch gekennzeichnet, daß das Eintreiben der zwei Störstofftypen durch Erhitzen des Substrats (25) auf wenigstens 1000°C erzielt wird.

7. Verfahren nach Anspruch 6, dadurch gekennzeichnet, daß das Substrat (25) mindestens 100 Minuten erhitzt wird.

8. Verfahren nach Anspruch 1, bei welchem das Einbringen der Störstoffe des ersten Leitungstyps und des entgegengesetzten Leitungstyps die Ionenimplantation der Störstoffe des ersten und des entgegengesetzten Leitungstyps umfaßt.

9. Verfahren nach Anspruch 1, bei welchem das Einbringen der Störstoffe des ersten und des entgegengesetzten Leitungstyps das Dotieren des Substrats (25) aus einer Quelle umfaßt.

10. Verfahren nach Anspruch 9, bei welchem die Quelle eine darüberliegende dotierte Schicht ist.

11. Verfahren nach Anspruch 9, bei welchem die Quelle aus Dampf besteht.

12. Integrierte Schaltungsstruktur (Fig. 3b) mit:

einem Halbleitersubstrat eines ersten Leitungstyps, das eine Zone (46) des entgegengesetzten Leitungstyps enthält, die Ladung enthält und aus der Überschußladung einer ausgewählten Menge entfernt werden soll;

einer Sperrzone (18) des ersten Leitungstyps, die stärker dotiert ist als das Substrat, wobei die Sperrzone in dem Substrat angrenzend an die eine Ladung enthaltende Zone angeordnet ist und sich bis zu einer ersten Tiefe in das Substrat erstreckt, damit Überschußladung mit einer ausgewählten Menge die Sperrzone durchdringen kann; und

einer Ladungsableitzone (16) des entgegengesetzten Leitungstyps, die vollständig innerhalb der Sperrzone (18) angeordnet ist, damit den Abschnitt der Sperrzone zwischen der Ladungsableitzone (16) und der eine Ladung enthaltenden Zone (46) durchdringende Ladung abgeleitet wird, wobei die Ladungsableitzone bis zu einer zweiten Tiefe in das Substrat reicht, die geringer als die erste Tiefe ist, und sowohl von der eine Ladung enthaltenden Zone als auch vom Substrat durch die Sperrzone getrennt ist.

13. Struktur nach Anspruch 12, dadurch gekennzeichnet, daß das Substrat aus Silicium besteht, der Störstoff des ersten Leitungstyps Bor ist und der Störstoff des entgegengesetzten Leitungstyps Arsen ist.

14. Struktur nach Anspruch 12, dadurch gekennzeichnet, daß die eine Ladung enthaltende Zone (46) ein Sensorelement in einer ladungsgekoppelten Vorrichtung ist.

15. Struktur nach Anspruch 14, dadurch gekennzeichnet, daß sich in dem Sensorelement als Reaktion auf einfallendes Licht Ladung ansammelt.

16. Struktur nach Anspruch 12, dadurch gekennzeichnet, daß die eine Ladung enthaltende Zone eine Schieberegisterzone unterhalb einer Elektrode in einer ladungsgekoppelten Vorrichtung ist.

17. Struktur nach Anspruch 16, dadurch gekennzeichnet, daß mehrere Schieberegisterzonen nacheinander angeordnet sind.

18. Struktur nach Anspruch 17, dadurch gekennzeichnet, daß die Sperrzone längs eines Randes der mehreren Schieberegisterzonen angeordnet ist.

19. Struktur nach Anspruch 12, mit der Sperrzone (18) und der Ladungsableitzone (16) auf einem Überlaufschutzmittel zum Ableiten einer unerwünschten Ladung von wenigstens einem lichtempfindlichen Mittel und mit dem Übertragungsmittel einer ladungsgekoppelten Vorrichtung, die in dem Halbleitersubstrat hergestellt ist, mit lichtempfindlichen Mittel zum Ansammeln von Ladung als Reaktion auf Umgebungslicht und Übertragungsmitteln zum Übertragen von Ladung von den lichtempfindlichen Mitteln zu einer anderen Stelle in dem Substrat.

**Revendications**

1. Procédé de fabrication d'une barrière anti-flou (18) pour un dispositif à couplage de charge ayant des photo-détecteurs (12) réalisés dans un substrat, comprenant les étapes consistant à:

réaliser une ouverture (28) dans une couche de masquage (30) disposée sur un substrat (25) d'un premier type de conductivité;

introduire à la fois des impuretés d'un premier type de conductivité et d'un type de conductivité opposé dans ledit substrat (25) au travers de l'ouverture (28) là où l'impureté du premier type a un coefficient de diffusion supérieur à celui de l'impureté de type opposé; et

faire pénétrer les impuretés du premier type de conductivité et du type de conductivité opposé dans le substrat par chauffage jusqu'à ce que l'impureté du premier type de conductivité diffuse suffisamment loin l'impureté de type de conductivité opposé pour entourer la région (16) du substrat qui présente une concentration plus élevée en impureté de type de conductivité opposé, pour ainsi former dans le substrat une barrière de potentiel (22a, 22b) de valeur prédéterminée liée au niveau de charge de saturation maximal ($Q_{12}$) pour les photo-détecteurs (12).

2. Procédé selon la revendication 1 caractérisé en ce que la diffusivité de l'impureté du premier type de conductivité est environ 2,5 fois supérieure à la diffusivité de l'impureté du type de conductivité opposé.

3. Procédé selon la revendication 2, caractérisé en ce qu'on introduit une concentration en impureté du type de conductivité opposé plus élevée que la concentration en impureté du premier de conductivité.

4. Procédé selon la revendication 2, caractérisé en ce que le premier type de conductivité est le type P et en ce que le type de conductivité opposé est le type N.

5. Procédé selon la revendication 4, caractérisé en ce que le substrat (25) est le silicium, en ce que l'impureté de type P est le bore et en ce que l'impureté de type N est l'arsenic.

6. Procédé selon la revendication 5, caractérisé en ce que l'étape consistant à faire pénétrer les deux types d'impureté est effectuée par chauffage du substrat (25) à une température d'au moins 1000°C.

7. Procédé selon la revendication 6, caractérisé en ce que le substrat (25) est chauffé pendant au moins 100 minutes.

8. Procédé selon la revendication 1, dans lequel les étapes d'introduction des impuretés du premier type de conductivité et du type de conductivité opposé comprennent l'implantation ionique des impuretés du premier type de conductivité et du type de conductivité opposé.

9. Procédé selon la revendication 1, dans lequel les étapes d'introduction des impuretés du premier type de conductivité et du type de conductivité opposé comprennent le dopage du substrat (25) à partir d'une source.

10. Procédé selon la revendication 9, dans lequel la source est une couche dopée sus-jacente.

11. Procédé selon la revendication 9, dans lequel la source est une vapeur.

12. Structure de circuit intégré (Fig. 3b) comprenant:

un substrat semi-conducteur d'un premier type de conductivité, le substrat comportant une région (46) d'un type de conductivité opposé destinée à contenir les charges et dont l'excès de charge par rapport à un certain niveau doit être éliminé;

une région barrière (18) du premier type de conductivité plus fortement dopée que le substrat, la région barrière étant disposée dans le substrat au voisinage d'une région contenant une charge et se prolongeant dans le substrat jusqu'à une première profondeur pour permettre le passage d'un excès de charge sélectionné au travers de la région barrière; et

une région formant puits de charge (16) du type de conductivité opposé entièrement située à l'intérieur de la région barrière (18) pour recevoir les charges traversant la partie de la région barrière séparant la région formant puits de charge (16) de la région contenant une charge (46), la région formant puits de charge se prolongeant dans le substrat jusqu'à une deuxième profondeur inférieure à la première profondeur et étant séparée tant de la région contenant une charge que substrat par la région barrière.

13. Structure selon la revendication 12, caractérisée en ce que le substrat est le silicium, en ce que l'impureté du premier type de conductivité est le bore et en ce que l'impureté du type de conductivité opposé est l'arsenic.

14. Procédé selon la revendication 12, caractérisé en ce que la région contenant une charge (46) est un élément détecteur dans un dispositif à couplage de charge.

15. Procédé selon la revendication 14, caractérisé en ce qu'une charge s'accumule dans l'élément détecteur en réponse à de la lumière incidente.

16. Procédé selon la revendication 15, caractérisé en ce que la région contenant une charge est une première région formant registre à décalage en-dessous d'une électrode d'un dispositif à couplage de charge.

17. Structure selon la revendication 16, caractérisée en ce qu'une pluralité de régions formant registres à décalage sont disposées séquentiellement.

18. Procédé selon la revendication 17, caractérisé en ce que la région barrière est disposée le long d'un bord de la pluralité de régions formant registres à décalage.

19. Structure selon la revendication 12, comprenant lesdites régions barrières (18) et à puits de charge (16) et un moyen anti-flou pour éliminer la charge indésirable d'au moins l'un des moyens photosensibles et des moyens de transfert du dispositif à couplage de charge réalisé dans un substrat semi-conducteur et comportant des moyens photosensibles pour accumuler une charge en réponse à la lumière ambiante et des moyens de transfert pour transférer la charge des moyens photosensibles vers un autre endroit du substrat.

FIG. Ia
OUTPUT REGISTER
VIDEO OUTPUT
IMAGING COLUMNS
STORAGE COLUMNS

FIG. Ib
17 18a 16 18b 12 14 10
CCD REGISTER
SENSOR ELEMENT WELL
CCD REGISTER
2 2

FIG. Ic
0
VOLTAGE
Q17 Q10
Q12 20
22a Q16 22b

FIG. 3a
OUTPUT REGISTER
VIDEO OUTPUT
STORAGE AREA
IMAGING AREA

FIG. 2
30 18a 28 18b 30
16 42 40
N N+ N
P
P-
25

FIG. 3c
φe

FIG. 3b
CHARGE FLOW IN SINK
CHARGE FLOW IN REGISTER
ANTIBLOOMING SPILL OVER
50 37 49
37
48 42 40
N N+ N N+ N
P P-
45 18 16 46 35 16 47
φ2 φ1

FIG. 5

FIG. 4

EP 0 069 649 B1

FIG. 6a

FIG. 6b

FIG. 6c

FIG. 7a

FIG. 7b

FIG. 7c

FIG. 8a

FIG. 8b

3

## FIG. 9a

## FIG. 9b